# EUROPÄISCHE PATENTANMELDUNG

(11) **EP 4 016 766 A1**
(43) Veröffentlichungstag der Anmeldung: **22.06.2022**
(21) Anmeldenummer: 21215396.9
(22) Anmeldetag: 17.12.2021
(51) Int. Cl.: H02B 1/26, H05G 1/02

(54) **SCHALTSCHRANKANORDNUNG**

(30) Priorität: 18.12.2020 DE 102020134288
(71) Anmelder: WIPOTEC Science & Innovation GmbH, 67657 Kaiserslautern (DE)
(72) Erfinder: Düppre, Theo, 67663 Kaiserslautern (DE); Hager, Steffen, 67678 Mehlingen (DE)
(74) Vertreter: Eder Schieschke & Partner mbB

(57) **Zusammenfassung**

Die Erfindung betrifft einen Schaltschrank (S), ein Gerätegehäuse (G) sowie eine aus beiden gebildete Anordnung, bei der eine Wand des Schaltschranks eine Öffnung im Gerätegehäuse (OG) wahlweise verschließt oder freigibt.

## Beschreibung

Die vorliegende Erfindung betrifft einen Schaltschrank zur Aufnahme elektrischer Installationen, für die gemeinsame Anordnung mit einem Gerätegehäuse.

Die elektrische Ausrüstung (Steuergeräte, Netzteile, Schütze usw.) von Geräten oder Maschinen wird üblicherweise in Gehäusen angeordnet. Unter "Gehäuse" ist hierbei eine Vorrichtung zu verstehen, welche einen innen liegenden Raum wenigstens teilweise, bevorzugt vollständig umgibt mit dem Ziel, den Raum vor äußeren Einflüssen zu schützen. Der Schutz kann sich auf mechanische Einwirkungen ebenso beziehen wie auf das Eindringen von Feststoffen, Flüssigkeiten oder Gasen. Die Eignung eines Gehäuses für den jeweils angestrebten Schutz kann benannt werden durch die sogenannte Gehäuseschutzart. Ein Röntgeninspektionsgerät mit der Gehäuseschutzart IP 69 K beispielsweise ist besonders gut gegen äußere Einflüsse geschützt.

Gehäuse für Maschinen und Geräte sollen nachfolgend vereinfacht als Gerätegehäuse bezeichnet sein. Sie sind in der Regel mit einer Zugangsbeschränkung versehen als Schutz für das Bedienpersonal. Dadurch soll sichergestellt werden, dass elektrische Spannung führende Teile nicht versehentlich berührt werden oder mit Flüssigkeiten und Schmutz in Kontakt gelangen. In der Regel verfügt das Gerätegehäuse dazu über eine durch eine Abdeckung, Klappe oder Gehäusetür verschließbare Gehäuseöffnung, durch die der Innenraum des Gerätegehäuses mit den darin befindlichen elektrischen Komponenten erreichbar ist. Das Gerätegehäuse soll möglichst allseitig abgedichtet sein, und etwaige Öffnungen müssen so angeordnet und geschützt sein, dass gefährliche Strom führende Teile von außen nicht erreichbar sind.

Manche Geräte, wie beispielsweise Röntgeninspektionsgeräte, werden mit Fluiden (strömungsfähigen Medien, bspw. Luft/Druckluft, Hydrauliköl oder anderen Flüssigkeiten) betrieben. Diese Fluide können als Schmiermittel oder insbesondere als Kühlmittel dienen, um eine Röntgenquelle zu kühlen. Dabei muss im Inneren des Gerätegehäuses besonders sorgfältig darauf geachtet werden, den Kontakt der Fluide mit spannungsführenden Teilen zu vermeiden, um das Bedienpersonal zu schützen oder der Entstehung von Kurzschlüssen oder Bränden vorzubeugen. In der Regel wird dazu versucht, die Flüssigkeitskreisläufe in strikt (hermetisch) von der Elektrik getrennten Sektionen (engl. Compartments) innerhalb des Gehäuses anzuordnen, wobei die gesetzlichen Bestimmungen bzw. die hierzu jeweils einzuhaltenden Standards von Land zu Land variieren können.

So ist es denkbar, dass im Land des Verwenders strengere Anforderungen gelten als im Land des Herstellers, sodass bspw. die Anordnung von Flüssigkeitskreisläufen und elektrischer Ausrüstung beim Hersteller noch innerhalb eines einzigen Gehäuses zugelassen ist, während im Land des Verwenders der Betrieb des Gerätes nur gestattet wird, wenn die elektrische Ausrüstung hermetisch abgetrennt in einem separaten Schaltschrank untergebracht ist. Oft wird die geforderte erhöhte Betriebssicherheit des Geräts von Prüforganisationen in Prüflabors bewertet und zertifiziert. Geräte ohne ein entsprechendes Zertifikat werden dann vom Verwender oder vom jeweiligen Gesetzgeber nicht akzeptiert.

Bestehen die erhöhten Anforderungen bereits bei der Entwicklung bzw. beim Bau des Gerätes, oder ergibt sich das Erfordernis erst im Nachhinein, beispielsweise aufgrund geänderter gesetzlicher Anforderungen oder neuer allgemein anerkannter Standards oder im Rahmen eines Umbaus oder einer Erweiterung, dann müssen jeweils geeignete Maßnahmen getroffen werden, um den neuen Anforderungen zu genügen. Ausgehend von der bisherigen Konfiguration des Geräts soll eine Weiterentwicklung oder Umrüstung des Geräts dabei möglichst einfach und kostengünstig möglich sein.

Aufgabe der Erfindung war es daher, ein modular erweiterbares, kostengünstiges Gehäuseschutzkonzept für elektrische Ausrüstungen anzubieten, welches ein skalierbares Schutzniveau und eine einfache nachträgliche Zertifizierung ermöglicht. Die Aufgabe wird gelöst durch einen Schaltschrank nach Anspruch 1, ein Gerätegehäuse nach Anspruch 3 oder eine Anordnung nach Anspruch 5. Weitere vorteilhafte Ausführungsformen ergeben sich aus den Unteransprüchen.

Die Erfindung geht von dem Gedanken aus, die im Gerätegehäuse vorhandene elektrische Ausrüstung gegen den möglichen Kontakt mit Fluiden zu schützen. Dazu könnte die Unterbringung der elektrischen Ausrüstung in einem räumlich abgetrennten Bereich innerhalb des Gerätegehäuses erfolgen. Erfindungsgemäß verbessert sich der angestrebte Schutz noch zusätzlich, indem die elektrische Ausrüstung weitgehend oder vollständig aus dem Gerätegehäuse ausgegliedert und in einem davon separierten Schaltschrank untergebracht wird. In einer besonders praktischen Umsetzung des Erfindungsgedankens kommt dem Schaltschrank dabei eine Doppelfunktion zu, indem er einerseits die in seinem Innenraum angeordnete elektrische Ausrüstung gegenüber dem Gerätegehäuse abdichtet und andererseits das Gerätegehäuse zugleich verschließt.

Der erfindungsgemäße Schaltschrank weist dabei zur Aufnahme elektrischer Ausrüstung einen gegenüber der Umgebung abzugrenzenden bzw. abzudichtenden Schaltschrank-Innenraum auf, wobei die Abgrenzung wenigstens eine Wand umfasst. Dabei kann es sich beispielsweise um eine Rückwand des Schaltschranks handeln, die vorzugsweise eben ist. Bevorzugt ist die Wand relativ zum Schaltschrank bzw. zum Schaltschrank-Innenraum unbeweglich. Sie kann fest mit einem Schaltschrankrahmen oder mit anderen Teilen des Schaltschrankgehäuses verbunden sein. Erfindungsgemäß ist der Schaltschrank dazu ausgebildet, mit der Wand eine Gehäuseöffnung in einem an den Schaltschrank angrenzenden Gerätegehäuse zu verschließen. Die Gehäuseöffnung kann beispielsweise auf der Rückseite eines Gerätegehäuses vorgesehen sein, um Zugang zum Gehäuseinneren zu gewährleisten. Mit einem erfindungsgemäßen Schrank ist es dabei besonders einfach möglich, (auch nachträglich) einen vom Gerätegehäuse abgetrennten Raum für elektrische Ausrüstung zu schaffen, um so erhöhten Sicherheits- und Zertifizierungsanforderungen bzw. einer geforderten Gehäuseschutzart entsprechen zu können.

Denkbar ist beispielsweise folgender Fall: In einem Röntgeninspektionsgerät sind Schläuche, Pumpen oder sonstige, Flüssigkeiten führende Komponenten und Leitungen zunächst gemeinsam mit der elektrischen Ausrüstung im Gerätegehäuse untergebracht. Aufgrund besonderer Sicherheitsanforderungen und/oder zur Erlangung eines besonderen Zertifikats wird es für bestimmte Verwender jedoch erforderlich, die elektrische Ausrüstung teilweise oder vollständig aus dem Gerätegehäuse herauszulösen und zum Beispiel hermetisch abgetrennt davon anzuordnen. Der erfindungsgemäße Schaltschrank gestattet es, einerseits die elektrische Ausrüstung aus dem Gerätegehäuse zu übernehmen, und andererseits mit seiner Wand die vorgenannte Gehäuseöffnung zum Gerätegehäuse hin zu verschließen, welche den Zugang zu den im Gerätegehäuse verbleibenden Komponenten bei Entfernung der Wand bzw. des Schaltschranks ermöglicht. Der Schaltschrank bildet dann eine modulartige Erweiterung des Gerätegehäuses.

Dadurch wird die Umrüstung und anschließende Handhabung des Röntgeninspektionsgeräts besonders einfach. Die oben genannte Gehäusetür, welche die Gehäuseöffnung vor der Umrüstung verschlossen hat, wird ersetzt durch die Wand eines erfindungsgemäßen Schaltschranks, der relativ zur Gehäuseöffnung verschwenkbar oder verfahrbar ist, um den Zugang ins Gehäuseinnere durch die Gehäuseöffnung wahlweise zu ermöglichen bzw. sicher zu verhindern. In einer Offen-Stellung, in der der Schaltschrank mit seiner Wand von der Gehäuseöffnung entfernt ist, sind die im Gerätegehäuse verbliebenen Komponenten erreichbar, beispielsweise für Installationen, Wartung oder Reparaturarbeiten. In einer Geschlossen-Stellung, in der die Wand des Schaltschranks die Gehäuseöffnung (vorzugsweise hermetisch) verschließt, bewirkt die Wand die gewünschte Trennung der Komponenten im Gerätegehäuse von der nun im Schaltschrank angeordneten elektrischen Ausrüstung. Die Wand erfüllt dabei erfindungsgemäß eine Doppelfunktion, da sie sowohl den Gehäuse-Innenraum als auch den Schaltschrank-Innenraum abdichtet bzw. abtrennt.

Die vorgenannte Umrüstung eines Geräts (beispielsweise zur Entfernung von elektrischen Ausrüstungen aus dem eigentlichen Gerätegehäuse) bzw. generell die modulartige Erweiterung eines Gerätegehäuses kann dann in einfacher Weise erfolgen, indem die Gehäusetür entfernt wird und stattdessen ein erfindungsgemäßer Schaltschrank bereitgestellt wird, der die aus dem Gerätegehäuse zu versetzenden elektrischen Komponenten aufnimmt und zugleich dazu ausgebildet ist, anstelle der Gehäusetür die Gehäuseöffnung in der Geschlossen-Stellung dicht zu verschließen. Der Schaltschrank ist dann als Erweiterungsmodul besonders nah am Gerätegehäuse positioniert, und unnötig lange elektrische Verbindungen zwischen Schaltschrank und Gerätegehäuse sind überflüssig.

Zugleich kann die Wand des Schaltschranks, welche den Innenraum des Gerätegehäuses vom Innenraum des Schaltschranks trennt, geeignete Kabeldurchführungen aufweisen, um die elektrische Verbindung aus dem Schaltschrank in das Gerätegehäuse zu ermöglichen. Eine Leitungsverlegung außerhalb des durch das Gerätegehäuse und den Schaltschrank gebildeten Gehäuseverbunds ist für die Installation oder Umrüstung nicht erforderlich. Zweckmäßigerweise sind die Durchführungen und der Kontaktbereich zwischen Wand und Gerätegehäuse so abgedichtet, dass den erhöhten Sicherheitsanforderungen entsprochen wird und der Durchtritt beispielsweise von Schmutz oder Staub oder Flüssigkeit oder Gasen aus dem Gerätegehäuse durch die Wand in den Raum des benachbarten Schaltschranks unterbunden wird.

Die erfindungsgemäße Anordnung aus Gerätegehäuse und Schaltschrankgehäuse zeichnet sich auch dadurch aus, dass der Schaltschrank selbst auch dann verschlossen bleiben kann, wenn er relativ zum Gerätegehäuse bewegt wird, um beispielsweise die Gehäuseöffnung freizugeben. Der angestrebte Schutz für die im Schaltschrank angeordneten Komponenten ist unabhängig davon gegeben, ob der Schaltschrank in der Geschlossen-Stellung oder in der Offen-Stellung angeordnet ist.

Nach einer vorteilhaften Ausführungsform der Erfindung ist vorgesehen, wenigstens eine elektrische Verbindung zwischen dem Schaltschrank und dem Gerätegehäuse durch manuell lösbare Steckverbindungen herzustellen. Dadurch lässt sich der Schaltschrank bzw. dessen elektrische Ausrüstung leicht vom Gerätegehäuse trennen, um beispielsweise Wartungs- oder Reparaturarbeiten vornehmen zu können. In einer alternativen Ausführungsform ist vorgesehen, dass die elektrische Verbindung bei Einnahme der Geschlossen-Stellung automatisch hergestellt und beim Bewegen des Schaltschranks in die Offen-Stellung automatisch getrennt wird. Dies kann mithilfe geeigneter zweiteiliger, bevorzugt komplementärer Steckverbindungen geschehen, deren Teile einerseits am Gerätegehäuse und andererseits am Schaltschrank angeordnet sind, und die bei Einnahme der Geschlossen-Stellung miteinander zusammenwirken.

Vorzugsweise ist der erfindungsgemäße Schaltschrank dazu ausgebildet, die Gehäuseöffnung des Gerätegehäuses hermetisch abzudichten, insbesondere gegen den Übertritt von Gasen und Flüssigkeiten. Dies kann dadurch gegeben sein, dass die die Gehäuseöffnung verschließende Wand des Schaltschranks geeignete Mittel aufweist, um diese Abdichtung zu erzielen. So kann die Wand beispielsweise ein bestimmtes Profil, Dichtmittel oder Beschläge aufweisen, die dazu ausgebildet sind, in der Geschlossen-Stellung mit dem Gerätegehäuse im Bereich der Gehäuseöffnung zusammenzuwirken. Denkbar sind aber auch Spannmittel am Schaltschrank (abseits der Wand), die mit geeigneten Spannmitteln am Gerätegehäuse zusammenwirken können, um den Schaltschrank mit seiner Wand in der Geschlossen-Stellung gegen die Gehäuseöffnung zu bewegen und zu spannen und/oder zu verriegeln.

Der erfindungsgemäße Schaltschrank kann in unterschiedlicher Weise dazu ausgebildet sein, mit seiner Wand aus der die Gehäuseöffnung verschließenden Geschlossen-Stellung in die die Gehäuseöffnung freigebende Offen-Stellung und zurück bewegt zu werden. So könnte der Schrank beispielsweise um eine vorzugsweise vertikale oder horizontale Schwenkachse verschwenkt werden, wobei die Wand des Schranks in einer Schwenkstellung die Gehäuseöffnung verschließt und in einer anderen öffnet. Der Schrank könnte dazu mit Scharnieren am Gerätegehäuse dauerhaft oder lösbar befestigt sein. Alternativ könnte der Schrank Mittel aufweisen, mit deren Hilfe er mit seiner Wand parallel zu dieser Wand vor die Gehäuseöffnung oder davon weg verschoben werden kann, nach Art einer Schiebetür. Beispielsweise könnte der Schrank eine Führungsschiene (vorzugsweise mit Endanschlag) aufweisen oder nutzen, welche diese Bewegung relativ zum Gerätegehäuse bzw. zur Gehäuseöffnung ermöglicht oder kontrolliert. Ähnliche Führungsmittel könnten auch vorgesehen sein, um den Schrank kontrolliert senkrecht zur Gehäuseöffnung auf sie zu bzw. von ihr weg zu verschieben.

Die Erfindung betrifft auch ein Gerätegehäuse der zuvor beschriebenen Art, welches dazu ausgebildet ist, seine Gehäuseöffnung mittels der Wand eines zuvor beschriebenen erfindungsgemäßen Schaltschranks zu verschließen. Das Gerätegehäuse kann sich für diesen Zweck beispielsweise dadurch eignen, dass die Gehäuseöffnung wahlweise entweder durch eine für das Gerätegehäuse vorgesehene Gehäusetür oder durch die Wand eines erfindungsgemäßen Schaltschranks verschließbar ist. Alternativ könnte das Gerätegehäuse Mittel aufweisen, um gezielt mit der Wand eines erfindungsgemäßen Schaltschranks zusammenzuwirken, um die Geschlossen-Stellung einnehmen zu können. Das Gerätegehäuse könnte auch durch geeignete Beschläge dazu geeignet sein, einen erfindungsgemäßen Schaltschrank bzw. dessen Rückwand in der Geschlossen-Stellung am Gerätegehäuse zu fixieren.

Die erfindungsgemäße Anordnung umfasst ein Gerätegehäuse und wenigstens einen Schaltschrank der zuvor beschriebenen Art und ist dadurch gekennzeichnet, dass das Gerätegehäuse und der Schaltschrank dazu ausgebildet sind, miteinander so in Wechselwirkung zu treten, dass die Wand des Schaltschranks die Gehäuseöffnung gezielt (und vorzugsweise hermetisch) verschließen kann. Der Schaltschrank könnte über ein Scharnier am Gerätegehäuse befestigt sein, so dass er relativ zum Gerätegehäuse verschwenkbar ist, um die Gehäuseöffnung wahlweise freizugeben oder zu verschließen. Denkbar sind auch Führungsschienen oder sonstige Führungsmittel, welche die Relativbewegung von Schaltschrank und Gerätegehäuse zwischen der Offen-Stellung und der Geschlossen-Stellung kontrollieren.

Der erfindungsgemäße Schaltschrank kann auf einer (vorzugsweise der Wand gegenüberliegenden) Seite eine Schaltschranköffnung aufweisen, die in herkömmlicher Weise durch eine Schaltschranktür verschließbar ist. Durch diese Tür ist der Innenraum des Schaltschranks erreichbar, und bei geschlossener Schaltschranktür ist Unbefugten der Zugang zum Schaltschrank verwehrt. Vorzugsweise bildet die die Gehäuseöffnung verschließende Wand des Schaltschranks dessen Rückseite, während die Schaltschranktür der Wand gegenüberliegt und die Vorderseite des Schaltschranks bildet.

Der erfindungsgemäße Gedanke der modulartigen Erweiterung des Gerätegehäuses kann erweitert auch angewendet werden auf zwei Schaltschränke. So lässt sich eine Schaltschranktür eines ersten Schaltschranks ersetzen durch die Wand bzw. Rückwand eines zweiten Schaltschranks, der anstelle der Schaltschranktür des ersten Schaltschranks vor dem ersten Schaltschrank positioniert wird, um diesen zu verschließen. So lässt sich ein Schaltschrank oder die erfindungsgemäße Anordnung eines Gerätegehäuses mit zugehörigem Schaltschrank modulartig bzw. kaskadenartig weiter erweitern. Bei zwei unmittelbar aneinandergrenzenden, beispielsweise hintereinander angeordneten, Schaltschränken einer solchen Anordnung verschließt die (Rück-)Wand des einen (vorderen) Schaltschranks die (vordere) Schaltschranköffnung des angrenzenden anderen (hinteren) Schaltschranks, auf dessen Schaltschranktür dann verzichtet werden kann.

Erfolgt die Abdichtung zweier derart hintereinander angeordneter Schaltschränke mit der dazwischenliegenden Wand hermetisch, also weitgehend gas- und flüssigkeitsdicht, so ist es auch denkbar, in einem Schaltschrank Komponenten anzuordnen, die mit Flüssigkeiten oder Gasen beaufschlagt sind, während der benachbarte Schaltschrank eine davon getrennte elektrische Ausrüstung aufnimmt, ähnlich wie bei der oben beschriebenen Kombination "Gerätegehäuse - Schaltschrank".

Nach einer vorteilhaften Ausführungsform der erfindungsgemäßen Anordnung von Gerätegehäuse und Schaltschrank ist vorgesehen, dass der Schaltschrank eine Schaltschranktür zum Verschließen einer Schaltschranköffnung aufweist. Die Schaltschranköffnung bzw. die zugehörige Schaltschranktür liegt vorzugsweise der Wand des Schaltschranks gegenüber, so dass die Wand die Rückwand des Schaltschranks bildet, während die Schaltschranktür die Schaltschranköffnung auf der Vorderseite des Schaltschranks verschließt. In dieser Ausführungsform ist das Gerätegehäuse bzw. dessen Gehäuseöffnung so ausgebildet, dass anstelle der Wand eines zu entfernenden Schaltschranks dessen Schaltschranktür dazu verwendbar ist, die Gehäuseöffnung des Gerätegehäuses zu verschließen, die Tür "passt" auf beide Öffnungen. Die alternative Verwendbarkeit der Schaltschranktür sowohl für die Schaltschranköffnung als auch für die Gehäuseöffnung kann sich beispielsweise daraus ergeben, dass:
a) die geometrischen Abmessungen beider Öffnungen weitgehend übereinstimmen, und/oder
b) die Beschläge zur Anordnung der Tür an beiden Öffnungen gleich sind, und/oder
c) die Tür mit unterschiedlichen Befestigungsmitteln versehen ist, von denen einige zur Befestigung der Tür an der Schaltschranköffnung und andere zur Befestigung der Tür an der Gehäuseöffnung verwendbar sind.

Die genannte doppelte Verwendbarkeit der Tür erleichtert die modulare Erweiterung oder auch Reduzierung einer erfindungsgemäßen Anordnung um einen oder mehrere (bevorzugt gleichartige) Schaltschränke. Soll beispielsweise das Gerätegehäuse eines Röntgeninspektionsgeräts erstmalig um einen Schaltschrank erweitert werden, so kann die Tür, mit der zuvor die Gehäuseöffnung des Röntgeninspektionsgeräts verschlossen wurde, umgesetzt werden auf die Vorderseite des zusätzlich vorzusehenden Schaltschranks, um dort die Schaltschranköffnung zu verschließen. Die Gehäuseöffnung des Röntgeninspektionsgeräts wird in erfindungsgemäßer Weise stattdessen durch die Wand des hinzugefügten Schaltschranks verschlossen. Bei Hinzufügen weiterer Schaltschränke erfolgt das Umsetzen der Tür in entsprechender Weise auf die Schaltschranköffnung des vordersten Schaltschranks, während die dazwischenliegenden Schaltschranköffnungen der einzelnen Schaltschränke durch die Wand des jeweils davor angeordneten nächsten Schaltschranks verschlossen werden.

In umgekehrter Weise können aus einer erfindungsgemäßen Anordnung mit einem Gerätegehäuse und einem oder mehreren davor angeordneten Schaltschränken einer oder mehrere dieser Schaltschränke entfernt werden, wobei die Schaltschranktür an der dabei freigelegten Schaltschranköffnung (wenn mindestens ein Schaltschrank in der Anordnung verbleibt) oder der Gehäuseöffnung (wenn nach der Umrüstung nur noch das Gerätegehäuse verbleibt) angeordnet werden kann.

Eine solche Ausführung mit einer Tür, die sowohl auf die Gehäuseöffnung als auch auf eine Schaltschranköffnung passt, reduziert vorteilhaft den Aufwand für Lagerhaltung und die Anzahl der bereitzuhaltenden Teile, da die Tür, ihre Dichtung und die Beschläge für beide Anwendungen infrage kommen.

Eine erfindungsgemäße Anordnung aus einem Gerätegehäuse und wenigstens einem damit zusammenwirkenden Schaltschrank ist bevorzugt so ausgebildet, dass der Schaltschrank in der Geschlossen-Stellung, also wenn seine Wand die Gehäuseöffnung verschließt, mit dem Gehäuse verriegelbar ist durch geeignete Verriegelungsmittel, die auch einen Schlüssel umfassen können. Bevorzugt handelt es sich dabei um einen Schaltschrankschlüssel, mit dem auch eine Schaltschranktür verriegelbar ist. Auch mehrere unmittelbar aneinander angrenzende Schaltschränke, von denen jeweils einer in der vorstehend beschriebenen Weise eine Schaltschranköffnung eines unmittelbar benachbarten weiteren Schaltschranks verschließt, können relativ zueinander mittels eines solchen Schaltschrankschlüssels verriegelbar sein. Dann genügt praktischerweise ein Schlüssel, mit dem sowohl die Schaltschranktür des vordersten Schaltschranks als auch beispielsweise zwei aneinandergrenzende Schaltschränke und ein die Gehäuseöffnung des Gerätegehäuses abdeckender Schaltschrank in der Geschlossen-Stellung verriegelbar sind. Alternativ können verschiedene Schlüssel bzw. Zugangsmittel vorgesehen sein, die mit verschiedenen Zugangsrechten verknüpft sind, so dass beispielsweise das Entriegeln bzw. der Zugang zur Gehäuseöffnung einen anderen Schlüssel erfordert als die Entriegelung bzw. der Zugang zu einer Schaltschranköffnung.

Bei einer Anordnung mit einem Gerätegehäuse und einem oder mehreren Schaltschränken muss das Gewicht der Schaltschränke sicher aufgenommen werden. Dazu könnten die Schaltschränke bspw. mit eigenen Füßen oder Rollen versehen sein, um auf dem Boden aufstehend relativ zum Gerätegehäuse oder anderen Schaltschränken bewegbar oder verfahrbar zu sein. Denkbar ist auch der Fall, dass ein Schaltschrank hängend am Gerätegehäuse oder einem angrenzenden weiteren Schaltschrank angeordnet und relativ dazu schwenkbar ist im Sinne einer Tür, deren Gewicht von dem angrenzenden Gehäuse aufgenommen wird. Die gesamte (zusammenhängende) Anordnung ist dann, bspw. für einen Wechsel des Aufstellortes, leichter zu bewegen als das Gerätegehäuse mit mehreren einzeln stehenden Schaltschränken. Allerdings muss das Gerätegehäuse mit seinen Rollen oder Standfüßen dann so ausgebildet sein, dass es mitsamt den von ihm getragenen Schaltschränken sicher steht, und zwar auch dann, wenn einer oder mehrere Schaltschränke in die Offen-Stellung überführt werden.

Nachfolgend soll die Erfindung anhand zweier Ausführungsformen näher erläutert werden. Dabei zeigen
- Figur 1 und 2: eine erfindungsgemäße Anordnung in einer ersten Perspektive,
- Figur 3 und 4: die Anordnung gemäß Figur 1 aus einer anderen Perspektive, und
- Figur 5: eine Anordnung mit mehreren Schaltschränken.

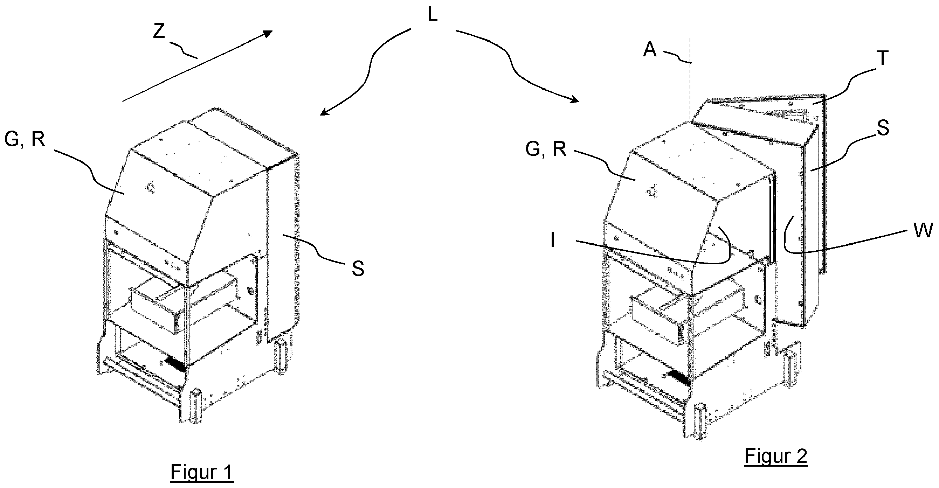

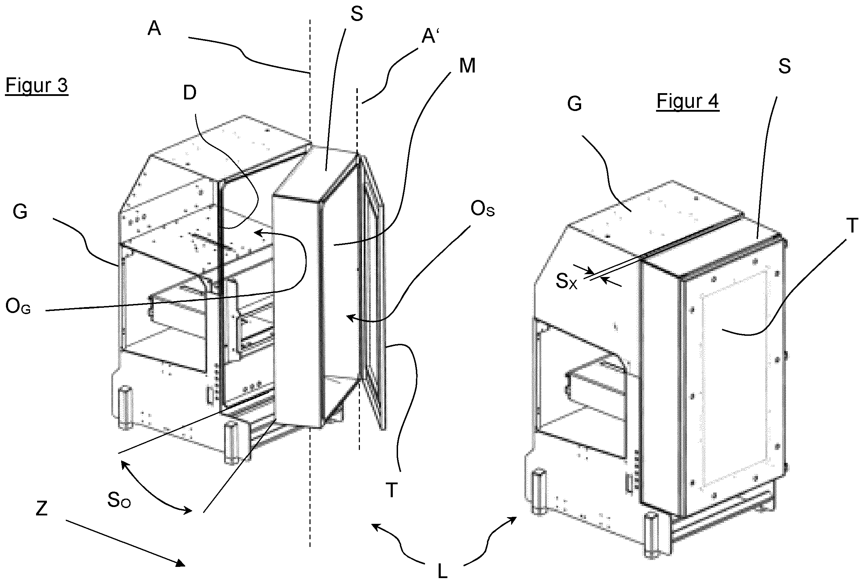

Figur 1 zeigt in perspektivischer und vereinfachter Darstellung ein Röntgeninspektionsgerät R mit einem Gerätegehäuse G, welches auf einem nicht näher dargestellten Untergrund ruht. Das Gerätegehäuse G nimmt in seinem Gehäuse-Innenraum I (siehe Figur 2) nicht näher dargestellte Komponenten des Röntgeninspektionsgeräts R auf, wozu beispielsweise mit Kühlmittel beaufschlagte Komponenten wie eine Röntgenröhre, ein Chiller, ein Entfeuchter, ein Kühlgerät, zugehörige Rohre oder Schläuche gehören können. In einer Tiefenrichtung Z schließt sich unmittelbar an das Gerätegehäuse G ein Schaltschrank S an. Der Schaltschrank S umschließt einen Schaltschrank-Innenraum M (siehe Figur 3), der zur Aufnahme nicht näher dargestellter elektrischer Ausrüstung vorgesehen ist, die zum Betrieb des Röntgeninspektionsgeräts R erforderlich ist. Um besonderen Sicherheitsanforderungen zu entsprechen, ist der Innenraum M des Schaltschranks S hermetisch vom Gehäuse-Innenraum I des Röntgeninspektionsgeräts R abgetrennt. Wie Figur 2 verdeutlicht, umfasst der Schaltschrank S dazu eine seine Rückwand bildende Wand W.

Auf einer der Wand W abgewandten und von Bedienpersonal zugänglichen Vorderseite wird der Schaltschrank S von einer Schaltschranktür T verschlossen, die in Figur 2 und 3 in leicht geöffneter Position und in Figur 4 in geschlossener Stellung dargestellt ist.

Wie insbesondere Figur 3 in einer anderen perspektivischen Ansicht verdeutlicht, weist das Gerätegehäuse G an seiner dem Schaltschrank S zugewandten Rückseite eine Gehäuseöffnung O_{G} auf, durch welche der Gehäuse-Innenraum I zugänglich ist. Um die Gehäuseöffnung O_{G} und damit den Gehäuse-Innenraum I gegenüber der Umgebung zu verschließen, ist der Schaltschrank 3 relativ zum Gerätegehäuse G um eine vertikale Schwenkachse A zwischen einer Offenstellung Sₒ und einer in Figur 4 dargestellten Geschlossen-Stellung Sₓ schwenkbar. In der Geschlossen-Stellung verschließt die Wand W des Schaltschranks die Gehäuseöffnung O_{G} vollständig und hermetisch, so dass beispielsweise flüssiges oder gasförmiges Kühlmittel nicht durch die Gehäuseöffnung O_{G} in die Umgebung und insbesondere in den Schaltschrank S eindringen kann. Die Abdichtung wird unterstützt durch eine am Rand der Gehäuseöffnung O_{G} im Gerätegehäuse vorgesehene und die Öffnung umlaufende Dichtung D, welche in der Geschlossen-Stellung von der Wand W des Schaltschranks S beaufschlagt wird.

In der in Figur 2 und 3 gezeigten Offenstellung So dagegen ist der Gehäuse-Innenraum I des Röntgeninspektionsgeräts R zugänglich (die gezeigte Offenstellung So ist nur beispielhaft gewählt. Sie gewährt zwar auch bei dem gezeigten geringen Öffnungswinkel Zugang zum Gehäuseinneren I, allerdings kann dieser Zugang durch weiteres Verschwenken des Schaltschranks S weg von der Gehäuseöffnung noch verbessert werden. Je nach Ausgestaltung der Anbindung des Schaltschranks S an das Gerätegehäuse G im Bereich der Schwenkachse A kann der Schaltschrank S aus der Geschlossen-Stellung auch um mehr als 90° verschwenkt werden, um nahezu ungehinderten Zugang in das Gehäuseinnere I zu erlauben.)

Figur 3 zeigt außerdem, dass der Schaltschrank S eine Schaltschranköffnung Os aufweist, die in den Schaltschrank-Innenraum M führt. Die Schaltschranköffnung liegt der Wand W des Schaltschranks gegenüber und kann von der Schaltschranktür T verschlossen werden. Dazu ist die Schaltschranktür T am Rahmen des Schaltschranks S so angeordnet, dass sie um eine zur Schwenkachse A parallele Schwenkachse A' relativ zum Rahmen des Schaltschranks S schwenkbar ist. Beide Schwenkachsen A, A' liegen dabei auf der gleichen Seite der Anordnung, so dass (mit Blick auf die Anordnung von oben) sowohl der Schaltschrank S als auch dessen Schaltschranktür T zum Öffnen der jeweiligen Öffnung O_{G}, O_{S} jeweils gegen den Uhrzeigersinn verschwenkt werden. Alternativ ist es jedoch auch möglich, die Schwenkachsen bspw. abwechselnd versetzt auf der einen und der anderen Seite der Anordnung vorzusehen, so dass die Öffnungsbewegungen abwechselnd im und entgegen dem Uhrzeigersinn erfolgen.

Die Gehäuseöffnung O_{G} des Röntgeninspektionsgeräts R hat die gleichen Maße wie die Schaltschranköffnung. Zugleich ist die Schaltschranktür T dazu ausgebildet, statt am Rahmen des Schaltschranks auch unmittelbar am Gerätegehäuse G befestigt zu werden, so dass die Gehäuseöffnung O_{G} - wenn auf den Schaltschrank S verzichtet werden kann - statt mit der Wand W des Schaltschranks S auch mit der vom Schaltschrank S unmittelbar an das Gerätegehäuse versetzten Schaltschranktür T verschlossen werden kann. Die Gehäuseöffnung O_{G} und die Schaltschranköffnung Os sind zu diesem Zweck gleichartig ausgeführt. Die Schaltschranktür könnte in diesem Fall auch als Gehäusetür bezeichnet werden, da sie je nach Montage wahlweise das Gerätegehäuse G oder den Schaltschrank S verschließen kann. Umgekehrt ist ersichtlich, dass eine zuvor die Gehäuseöffnung O_{G} abdeckende Gehäusetür nach Zwischenschaltung eines Schaltschranks S stattdessen auch an die Vorderseite des Schaltschranks S versetzt werden kann, um dort die Schaltschranköffnung Os wahlweise zu verschließen oder freizugeben.

Aus den Figuren 1 bis 4 wird deutlich, dass sich das Gerätegehäuse G mithilfe des Schaltschranks S auf einfache Weise modular erweitern oder reduzieren lässt. Ein zunächst ohne ergänzenden Schaltschrank S ausgebildetes Röntgeninspektionsgerät R lässt sich durch Anordnung des Schaltschranks S in der dargestellten Weise leicht umrüsten, um beispielsweise bestimmte Komponenten aus dem Gehäuse-Innenraum I des Röntgeninspektionsgeräts R in den angrenzenden Schaltschrank S auszulagern und dadurch vom Gehäuse-Innenraum zu trennen. Anstatt einen separat zu platzierenden, eigenständigen Schaltschrank dafür vorzusehen, wird der Schaltschrank S erfindungsgemäß so am Gerätegehäuse angeordnet, dass er mit seiner Wand W in der Geschlossen-Stellung den Gehäuse-Innenraum I vom Schaltschrank-Innenraum M abtrennt. Die Wand W erfüllt dabei eine Doppelfunktion, da sie sowohl den Gehäuse-Innenraum als auch den Schaltschrank-Innenraum abgedichtet bzw. abtrennt.

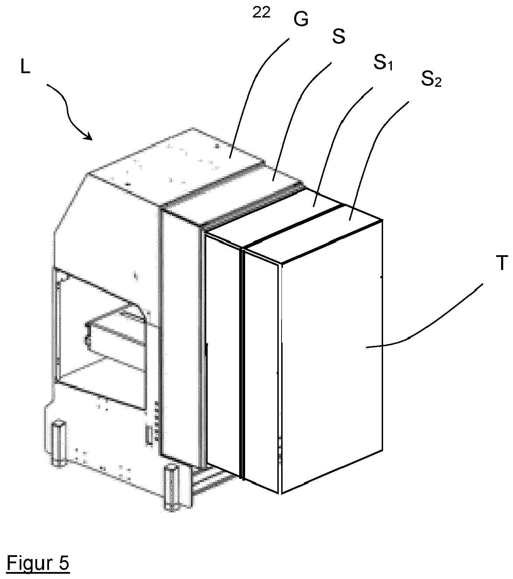

Figur 5 zeigt eine Weiterbildung des der Erfindung zugrunde liegenden Gedankens in vereinfachter Darstellung. Ein Gerätegehäuse G ist in der bereits beschriebenen Weise um einen Schaltschrank S erweitert worden. Die Anordnung aus Gerätegehäuse G und Schaltschrank S wurde um zwei weitere Schaltschränke S₁ und S₂ ergänzt. Der Schaltschrank S verschließt in erfindungsgemäßer Weise mit seiner Wand W die Gehäuseöffnung O_{G} des Gerätegehäuses G (wobei die verdeckten Öffnungen bzw. Wände in Figur 5 nicht zu sehen sind). Der weiterhin hinzugefügte nächste Schaltschrank S₁ verschließt in erfindungsgemäßer Weise mit seiner Rückwand die Schaltschranköffnung des Schaltschranks S, während der weiterhin hinzugefügte Schaltschrank S₂ wiederum die Schaltschranköffnung des ersten Schaltschranks S₁ verschließt. Der Schaltschrank S₂ ist auf seiner Vorderseite mit einer Schaltschranktür T verschlossen. Alle Schaltschränke sind relativ zueinander um eine nicht näher dargestellte vertikale Schwenkachse verschwenkbar, sodass die Schaltschrank-Innenräume der einzelnen Schaltschränke bzw. der Gehäuse-Innenraum des Gerätegehäuses I zugänglich werden, indem die vor der betreffenden Öffnung angeordneten Schaltschränke zur Seite weggeschwenkt werden.

### Bezugszeichenliste

- A, A': Schwenkachse
- D: Dichtung
- G: Gerätegehäuse
- I: Gehäuse-Innenraum
- L: Anordnung
- M: Schaltschrank-Innenraum
- O_{G}: Gehäuseöffnung
- Os: Schaltschranköffnung
- R: Röntgeninspektionsgerät
- S, S₁, S₂...: Schaltschrank
- So: Offen-Stellung
- Sx: Geschlossen-Stellung
- T: Schaltschranktür
- Z: Tiefenrichtung
- W: Wand des Schaltschranks

## Patentansprüche

1. Anordnung (L), umfassend ein Gerätegehäuse (G) und wenigstens einen Schaltschrank (S),
a) wobei der Schaltschrank (S) zur Aufnahme elektrischer Ausrüstung ausgebildet ist, umfassend wenigstens einen gegenüber der Umgebung abzugrenzenden Schaltschrank-Innenraum (M), wobei die Abgrenzung eine vorzugsweise ebene Wand (W) umfasst, und
b) wobei das Gerätegehäuse (G) eine mit Fluid beaufschlagbare Komponente eines Röntgeninspektionsgeräts aufweist, dessen Röntgenquelle mit einem Kühlmittelfluid, insbesondere Luft oder Kühlmittelflüssigkeit, gekühlt wird,
c) und wobei das Gerätegehäuse (G) eine Gehäuseöffnung (O_{G}) umfasst und der an die Gehäuseöffnung (O_{G}) des Gerätegehäuses (G) angrenzende Schaltschrank (S) elektrische Komponenten und/oder Steuerungselemente für das Röntgeninspektionsgerät enthält,
d) und wobei der Schaltschrank (S) dazu ausgebildet ist, mit seiner Wand (W) eine Gehäuseöffnung (O_{G}) in dem an den Schaltschrank (S) angrenzenden Gerätegehäuse (G) in einer Geschlossen-Stellung (Sₓ) zu verschließen und in einer Offen-Stellung (Sₒ) freizugeben, und
e) und wobei die Wand (W) des Schaltschranks (S) die Gehäuseöffnung (O_{G}) des Gerätegehäuses (G) in der Geschlossen-Stellung (Sₓ) verschließt,
f) und wobei die Wand (W) des Schaltschranks (S) die Gehäuseöffnung (O_{G}) in der Geschlossen-Stellung (Sₓ) abdichtet gegen den Durchtritt von Flüssigkeiten.

2. Anordnung (L) nach Anspruch 1, **dadurch gekennzeichnet, dass** die Wand des Schaltschranks (S) relativ zur Gehäuseöffnung (O_{G}) aus der Geschlossen-Stellung (Sx) in die Offen-Stellung (So) und zurück bewegbar ist, indem der Schaltschrank mit seiner Wand (W)
a) um eine vorzugsweise vertikale oder horizontale Schwenkachse (A) verschwenkt wird, oder
b) parallel zur Wand vor die Gehäuseöffnung (O_{G}) oder davon weg verschoben wird, oder
c) in einer Bewegung senkrecht zur Gehäuseöffnung (O_{G}) auf sie zu bzw. von ihr weg verschoben wird, oder
d) in einer Überlagerung mehrerer der Bewegungen nach a) bis c) bewegt wird.

3. Anordnung (L) nach Anspruch 1, **dadurch gekennzeichnet, dass** das Gerätegehäuse (G) Beschläge aufweist, die dazu vorgesehen und ausgebildet sind, mit einem Schaltschrank (S) nach Anspruch 1 oder 2 zusammenzuwirken, um eine kontrollierte Relativbewegung zwischen dem Gerätegehäuse (G) und dem Schaltschrank (S), insbesondere nach den Merkmalen a) bis d) des Anspruchs 2, zu ermöglichen.

4. Anordnung (L) nach Anspruch 1, umfassend mehrere Schaltschränke (S, S₁, S₂...) nach Anspruch, wobei der Raum (W) wenigstens eines Schaltschranks (S, S₁) eine Schaltschranköffnung (Os) aufweist, die von der Wand (W) eines angrenzenden weiteren Schaltschranks (S₁, S₂) verschlossen wird.

5. Anordnung (L) nach Anspruch 4, **dadurch gekennzeichnet, dass** die Wand (W) eines Schaltschranks (S, S₁, S₂...) die Gehäuseöffnung (O_{G}) oder die Schaltschranköffnung (Os) in der Geschlossen-Stellung (Sₓ) abdichtet, insbesondere gegen den Durchtritt von Schmutz, Staub, Gasen oder Flüssigkeiten.

6. Anordnung (L) nach Anspruch 1, **dadurch gekennzeichnet, dass** im Gerätegehäuse (G) mit Fluid beaufschlagbare Komponenten, insbesondere Rohre, Behälter oder Schläuche vorgesehen sind.

7. Anordnung (L) nach Anspruch 1, **dadurch gekennzeichnet, dass** der an das Gerätegehäuse (G) angrenzende Schaltschrank (S) eine vorzugsweise seiner Wand (W) gegenüberliegende Schaltschranköffnung (O_{S}) aufweist, die von einer Schaltschranktür (T) verschließbar ist, und wobei das Gerätegehäuse (G) dazu ausgebildet ist, die vom Schaltschrank (S) demontierte Schaltschranktür (T) so am Gerätegehäuse (G) zu montieren, dass anstelle der Wand (W) des Schaltschranks (S) dessen Schaltschranktür (T) dazu verwendbar ist, die Gehäuseöffnung (O_{G}) des Gerätegehäuses (G) zu verschließen.

8. Anordnung (L) nach Anspruch 1, **dadurch gekennzeichnet, dass** die Gehäuseöffnung (O_{G}) des Gerätegehäuses (G) mittels einer Tür verschließbar ist, und wobei der an das Gerätegehäuse (G) angrenzende Schaltschrank (S) eine vorzugsweise seiner Wand (W) gegenüberliegende Schaltschranköffnung (O_{S}) aufweist, die von einer Schaltschranktür (T) verschließbar ist, und wobei die Tür des Gerätegehäuses (G) von der Gehäuseöffnung (O_{G}) lösbar und als Schaltschranktür (T) an der Schaltschranköffnung (O_{S}) montierbar ist, um die Schaltschranköffnung (O_{S}) zu verschließen, während die Gehäuseöffnung (O_{G}) durch die Wand (W) des Schaltschranks (S) verschließbar ist.

9. Anordnung (L) nach einem der beiden vorhergehenden Ansprüche, **dadurch gekennzeichnet, dass** das Gerätegehäuse (G) an der Geräteöffnung (O_{G}) bzw. der Schaltschrank (S) an der Schaltschranköffnung (Os) jeweils die gleiche, mit der Schaltschranktür (T) kompatible Anordnung von Beschlägen aufweisen, so dass die Schaltschranktür (T) leicht von der Schaltschranköffnung (Os) an die Gehäuseöffnung (O_{G}) oder umgekehrt versetzbar ist.

10. Anordnung (L) nach Anspruch 1, wobei
a) das Gerätegehäuse (G) eine mit Fluid beaufschlagbare Komponente eines Gerätes oder einer Maschine aufweist, und ein an die Gehäuseöffnung (O_{G}) des Gerätegehäuses (G) angrenzender Schaltschrank (S) elektrische Komponenten und/oder Steuerungselemente für das Gerät oder die Maschine enthält, und
b) wobei die Wand (W) die Gehäuseöffnung (O_{G}) in der Geschlossen-Stellung (Sx) abdichtet (vorzugsweise unter Nutzung einer die Gehäuseöffnung (O_{G}) umlaufenden Dichtung), um eine vorgebbare Gehäuseschutzart zu erlangen, welche den Austritt oder das Eindringen von Schmutz, Staub, Flüssigkeiten oder Gasen aus dem bzw. in das Gerätegehäuse (G) durch die Gehäuseöffnung (O_{G}) reduziert oder verhindert.

11. Anordnung nach dem vorhergehenden Anspruch, **dadurch gekennzeichnet, dass** es sich bei dem Gerät oder der Maschine handelt um
a) ein Messgerät, insbesondere eine Waage, oder
b) ein Inspektions- oder Kontrollgerät

12. Anordnung (L) nach Anspruch 1, wobei die Gehäuseöffnung (O_{G}) begrenzt wird durch einen in einer Ebene liegenden Rand.
